# EUROPÄISCHE PATENTSCHRIFT

(11) **EP 3 491 744 B1**
(45) Veröffentlichungstag und Bekanntmachung des Hinweises auf die Patenterteilung: **20.10.2021**
(21) Anmeldenummer: 17748621.4
(22) Anmeldetag: 28.07.2017
(51) Int. Cl.: H04B 5/00, G01K 7/16, G06K 19/077

(54) **KOMMUNIKATIONSVORRICHTUNG**
COMMUNICATION APPARATUS
DISPOSITIF DE COMMUNICATION

(30) Priorität: 29.07.2016 AT 506922016
(43) Veröffentlichungstag der Anmeldung: 05.06.2019
(73) Patentinhaber: Sensideon GmbH, 4600 Wels (AT)
(72) Erfinder: BACHER, Christian, 4600 Wels (AT); FACHBERGER, René, 4600 Wels (AT)
(74) Vertreter: Hübscher & Partner Patentanwälte GmbH
(86) Internationale Anmeldenummer: PCT/AT2017/050019
(87) Internationale Veröffentlichungsnummer: WO 2018/018056

(56) Entgegenhaltungen:
- EP-A1- 2 348 461
- JP-A- 2001 236 485
- US-A1- 2015 332 140

## Beschreibung

### Technisches Gebiet

Die Erfindung bezieht sich auf eine Kommunikationsvorrichtung zum Einsatz in einem Gefahrenbereich mit einer, eine Öffnung zum Gefahrenbereich hin aufweisenden Aufnahme, in der ein Transponderelement in einer Vergussmasse eingebettet ist und mit einer, über eine Signalleitung mit dem Transponderelement verbundenen Übertragungseinrichtung.

### Stand der Technik

Zum Erfassen und Übertragen von Messdaten sind Kommunikationsvorrichtungen bekannt (DE 102014223653 A1, DE 102013010925 A1, US 2015/332140 A1), die einen Transponder zur Kommunikation aufweisen, der in einer Vergussmasse innerhalb einer Aufnahme vergossen ist. Mit dem Transponderelement ist für eine bessere Übertragungsleistung eine Antenne als Übertragungseinrichtung verbunden. Nachteilig ist an diesen bekannten Kommunikationsvorrichtungen, dass diese nicht unter extremen Umgebungsbedingungen in Gefahrenbereichen, wie beispielsweise bei hohen Temperaturen im Bereich von 300 bis 400°C, bei hoher Luftfeuchtigkeit oder bei aggressiver Wasserdampfatmosphäre sowie bei mechanischen Belastungen, wie Sie bei schnellen Rotationen auftreten, eingesetzt werden können, weil sie langfristig diesen Bedingungen nicht standhalten. Darüber hinaus ist eine elektrisch isolierende Abdichtung solcher Kommunikationsvorrichtungen bei hohen Temperaturen üblicherweise nur mittels gebrannter Keramik realisierbar, deren Brennen allerdings im gegebenen Anwendungsfall das Transponderelement beschädigen oder zerstören würde.

### Darstellung der Erfindung

Der Erfindung liegt somit die Aufgabe zugrunde, eine Kommunikationsvorrichtung der eingangs beschriebenen Art so auszugestalten, dass ein Einsatz in Gefahrenbereichen, insbesondere bei hohen Temperaturen im Bereich von über 300°C und unter dem Einfluss von Wasserdampf oder anderen aggressiven Medien ermöglicht wird.

Die Erfindung ist durch den unabhängigen Anspruch 1 definiert. Vorteilhafte Ausführungsformen ergeben sich aus den abhängigen Ansprüchen. Die Erfindung löst die gestellte Aufgabe dadurch, dass die Vergussmasse im Bereich der Öffnung mit einem durch ein Halteelement zum Gefahrenbereich hin gegen mechanische Belastung geschützten Hitzeschild versehen ist.

Der Erfindung liegt die Erkenntnis zugrunde, dass Transponderelemente einerseits gegen äußere Einflüsse, wie beispielsweise bei hoher Luftfeuchtigkeit, bei aggressiver Wasserdampfatmosphäre, bei starken elektrischen oder elektromagnetischen Feldern oder bei mechanischen Belastungen besonders gut durch Einbettung in Vergussmassen geschützt werden können und eine solche Einbettung andererseits thermische Ausdehnungen der eingebetteten Elemente kompensieren kann, wie dies beim Einsatz unter hohen Temperaturen erforderlich ist. Vergussmassen, wie erfindungsgemäß beispielsweise Silikonkautschuk, die einerseits eine hohe Elastizität und andererseits eine hohe Dichtheit zum Schutz der eingebetteten Komponenten aufweisen, trocknen allerdings unter dem Einfluss hoher Temperaturen aus, werden spröde und können Ihre Schutzfunktionen nicht mehr ausreichend erfüllen. Zufolge der erfindungsgemäßen Maßnahmen kann nun ein Austrocknen beziehungsweise eine chemische Zersetzung der Vergussmasse innerhalb der Aufnahme auch unter dem Einfluss hoher Temperaturen vermieden werden, sodass deren Schutzfunktion für das Transponderelement langfristig erhalten bleibt. Nachdem allerdings bei bekannten Hitzeschildelementen, wie beispielsweise bei Duroplasten, Glasfasergeweben oder Glimmerpapier eine verhältnismäßig geringe mechanische Stabilität gegeben ist, hat es sich als vorteilhaft erwiesen, das Hitzeschild durch ein Halteelement zum Gefahrenbereich hin gegen mechanische Belastungen abzuschirmen. Dieses Halteelement ist insbesondere auch zur Fixierung des Hitzeschildes bei schnellen Bewegungen wie Rotationen erforderlich, weil eine andere Verbindung des Hitzeschildes mit der Vergussmasse, wie beispielsweise ein Verkleben die Elastizität und chemische Beständigkeit der Vergussmasse gefährden würde. Selbstverständlich kann das Hitzeschild alternativ auch mit dem Halteelement kombiniert werden und als einzelnes Bauteil vorgesehen sein. Erfindungsgemäß kann die Aufnahme für das Transponderelement einerseits ein Bauteil oder Maschinenelement bilden, in dem das Transponderelement in der erfindungsgemäßen Art vergossen wird, oder aber ein eigenes Gehäuse, wie untenstehend näher erläutert wird.

Besonders vorteilhafte Eigenschaften ergeben sich, wenn das Halteelement eine auf das Transponderelement abgestimmte Antenne als Übertragungselement bildet. Eine solche Antenne kann beispielsweise als Edelstahl-Schlitzantenne oder als breite Metall-Loopantenne ausgeführt werden, die sich beide durch ihre hohe Robustheit auszeichnen.

Alternativ dazu kann aber auch zwischen Halteelement und dem Transponderelement eine Antenne als Übertragungseinrichtung vorgesehen sein, was den wesentlichen Vorteil mit sich bringt, dass das Hitzeschild nicht mit einer Signalleitung zwischen Transponderelement und Antenne durchbrochen werden muss. Gleichzeitig wird auch eine Leckage am Austrittsbereich der Signalleitung aus der Vergussmasse verhindert, weil in diesem Fall sowohl das Transponderelement als auch die Antenne gemeinsam in der Vergussmasse eingebettet sind.

In diesem Zusammenhang kann das Halteelement selbst eine Hochfrequenzblende bilden, wodurch sich eine hohe Flexibilität hinsichtlich der Bauform der unterhalb der Blende liegenden Antenne ergibt, weil die elektromagnetische Abstrahlcharakteristik der Antenne über die Hochfrequenzblende angepasst werden kann. Beispielsweise wird durch diese Maßnahme der Einsatz einer einfachen PCB-Antenne oder einer Drahtantenne möglich.

Die Kommunikationsvorrichtung kann erfindungsgemäß mit einem Sensor zur Erfassung physikalischer Eigenschaften der Umgebung oder der Aufnahme ausgestattet sein. Beispielsweise kann das Transponderelement einen Sensor zur Messung physikalischer Eigenschaften der Aufnahme, wie beispielsweise deren Temperatur, Dehnung, Schwingungsfrequenzen etc. aufweisen.

Um eine solche Messung zu erleichtern ist das Transponderelement thermisch an die Aufnahme gekoppelt. Diese Maßnahme bringt aber auch den Effekt mit sich, dass das Transponderelement über die Aufnahme gekühlt oder beheizt werden kann, um die Temperatur des Transponderelementes selbst zu regulieren. Dies ist besonders dann von Vorteil, wenn die Aufnahme durch größere metallische Körper oder mit solchen Körpern wärmeleitend verbundene Bauteile gebildet wird.

Um eine einfache Befestigung der erfindungsgemäßen Kommunikationsvorrichtung zu ermöglichen und eine Serienproduktion zu erleichtern, kann die Aufnahme ein mit Befestigungselementen versehenes Gehäuse bilden. Dieses Gehäuse kann beispielsweise ein Außengewinde oder einen Gewindeansatz zum Anschrauben der Kommunikationsvorrichtung an einen zu überwachenden Gegenstand aufweisen.

### Kurze Beschreibung der Erfindung

In der Zeichnung ist der Erfindungsgegenstand beispielsweise dargestellt. Es zeigen
- Fig. 1: eine erfindungsgemäße Kommunikationsvorrichtung in einem schematischen Schnitt in einer ersten Ausführungsform,
- Fig. 2: einen der Fig. 1 entsprechenden Schnitt einer weiteren Ausführungsform der Erfindung,
- Fig. 3: einen der Fig. 1 entsprechenden Schnitt der Kommunikationsvorrichtung mit thermischer Ankopplung an die Aufnahme und
- Fig. 4: einen der Fig. 1 entsprechenden Schnitt der Kommunikationsvorrichtung mit einem in ein zu überwachendes Bauteil eingeschraubten Gehäuse.

### Weg zur Ausführung der Erfindung

Eine erfindungsgemäße Kommunikationsvorrichtung umfasst ein Transponderelement 1, das über eine Signalleitung 2 mit einer Antenne 3 verbunden ist.

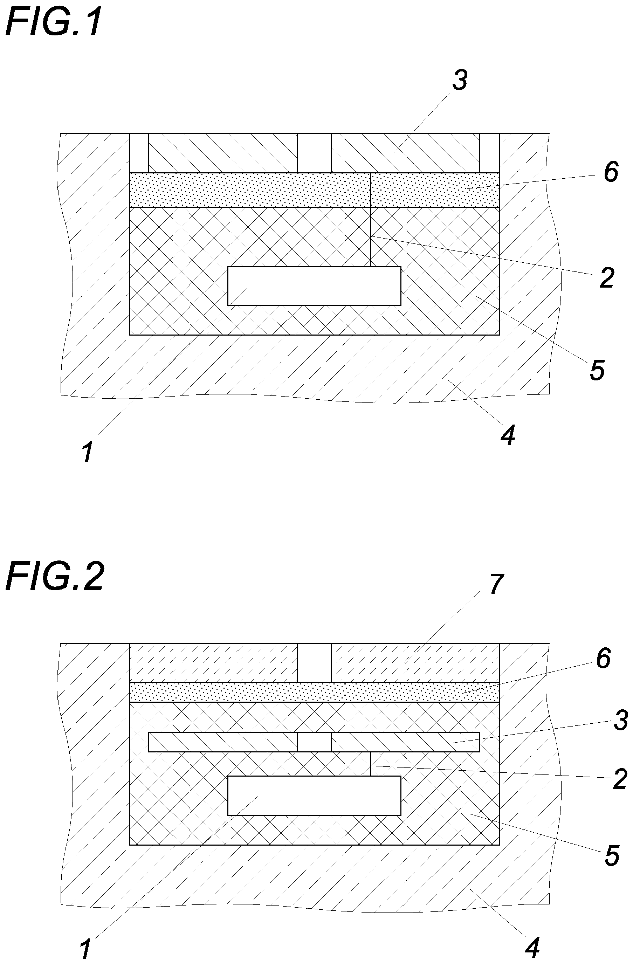

In der in der Fig. 1 dargestellten Ausführungsform ist das Transponderelement 1 innerhalb einer, beispielsweise durch ein Maschinenelement gebildeten Aufnahme 4 angeordnet und innerhalb dieser Aufnahme 4 mit einer Vergussmasse 5 vergossen. Diese Vergussmasse 5 zeichnet sich durch eine hohe Elastizität, Temperaturfestigkeit und Wasserdampfdichte aus. Beispielsweise kann daher als Vergussmasse 5 Silikonkautschuk zum Einsatz kommen. Um ein Austrocknen der Vergussmasse 5 sowie eine chemische Zersetzung derselben zu verhindern, ist diese zum Gefahrenbereich hin mit einem Hitzeschild 6 abgedeckt. In den Ausführungsformen der Fig. 1, 3 und 4 wird der Hitzeschild 6 zum Gefahrenbereich hin durch die Antenne 3 mechanisch stabilisiert.

In der Ausführungsform der Fig. 2 ist die Antenne 3 unterhalb des Hitzeschildes 6 in der Vergussmasse 5 gemeinsam mit dem Transponderelement 1 vergossen und die mechanische Stabilisierung des Hitzeschildes 6 zum Gefahrenbereich hin erfolgt über eine Hochfrequenzblende 7. Vorteilhaft ist an dieser Ausführungsform, dass auch einfachere Antennenbautypen wie beispielsweise eine einfache Drahtantenne zum Einsatz kommen können, weil die Richtcharakteristik der Kommunikationsvorrichtung über die Hochfrequenzblende 7 angepasst werden kann.

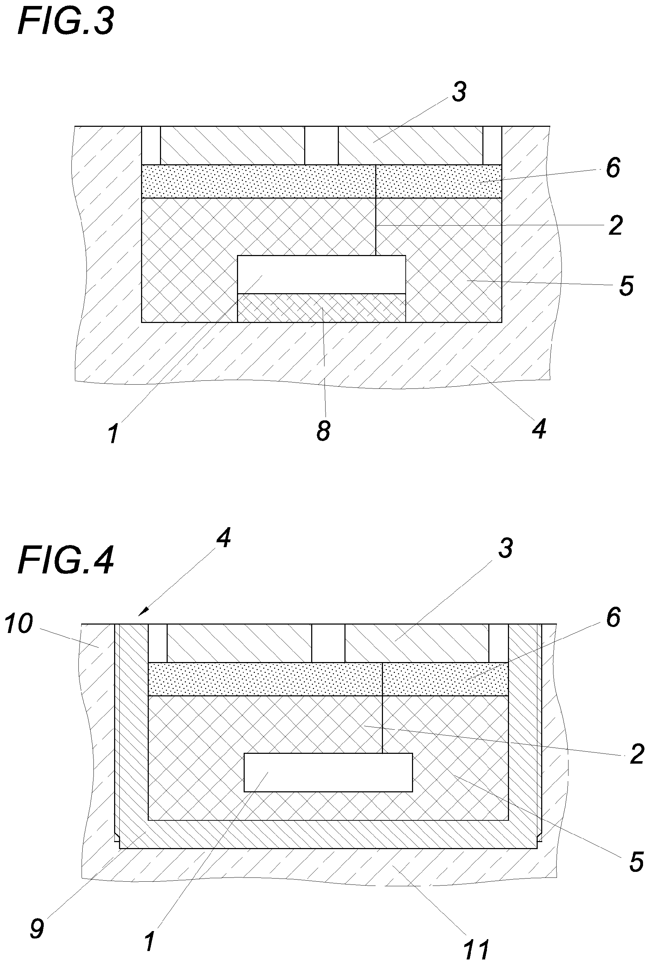

Erfindungsgemäss, wie in Fig. 3 dargestellt, ist das Transponderelement 1 über ein thermisch leitfähiges Bauteil, beispielsweise einen Metallkörper 8 an die Aufnahme 4 gekoppelt, sodass das Transponderelement 1 über die Aufnahme 4 gekühlt beziehungsweise beheizt werden kann.

Bei der Ausführungsform der Fig. 4 bildet die Aufnahme 4 ein Gehäuse 9, dass mit einem Außengewinde 10 zum Einschrauben in ein Maschinenelement 11 versehen ist, wodurch sich nicht nur eine einfache Fertigung und Montage, sondern auch ein einfacher Tausch der erfindungsgemäßen Kommunikationsvorrichtung ergibt.

## Patentansprüche

1. Kommunikationsvorrichtung zum Einsatz in einem Gefahrenbereich mit einer, eine Öffnung zum Gefahrenbereich hin aufweisenden Aufnahme (4), in der ein Transponderelement (1) in einer Vergussmasse (5) eingebettet ist und mit einer, über eine Signalleitung (2) mit dem Transponderelement (1) verbundenen Übertragungseinrichtung, wobei die Vergussmasse (5) im Bereich der Öffnung mit einem durch ein Halteelement zum Gefahrenbereich hin gegen mechanische Belastung geschützten Hitzeschild (6) versehen ist, **dadurch gekennzeichnet, dass** das Transponderelement (1) so über ein thermisch leitfähiges Bauteil an die Aufnahme (4) gekoppelt ist, dass das Transponderelement (1) über die Aufnahme (4) gekühlt beziehungsweise beheizt werden kann.

2. Kommunikationsvorrichtung nach Anspruch 1, **dadurch gekennzeichnet, dass** das Halteelement eine auf das Transponderelement (1) abgestimmte Antenne (3) als Übertragungselement bildet.

3. Kommunikationsvorrichtung nach Anspruch 1, **dadurch gekennzeichnet, dass** zwischen dem Halteelement und dem Transponderelement (1) eine Antenne (3) als Übertragungseinrichtung vorgesehen ist.

4. Kommunikationsvorrichtung nach Anspruch 3, **dadurch gekennzeichnet, dass** das Halteelement eine Hochfrequenzblende (7) bildet.

5. Kommunikationsvorrichtung nach einem der Ansprüche 1 bis 4, **dadurch gekennzeichnet, dass** das Transponderelement (1) einen Sensor zur Messung physikalischer Eigenschaften der Aufnahme (4) aufweist.

6. Kommunikationsvorrichtung nach einem der Ansprüche 1 bis 5, **dadurch gekennzeichnet, dass** die Aufnahme (4) ein mit Befestigungselementen versehenes Gehäuse (9) bildet.

## Claims

1. Communication apparatus for use in a hazard area, having a receptacle (4) which has an opening towards the hazard area and in which a transponder element (1) is embedded in a potting compound (5), and having a transmission device which is connected to the transponder element (1) via a signal line (2), wherein the potting compound (5) in the region of the opening is provided with a heat shield (6) which is protected against mechanical loading by means of a holding element towards the hazard area, **characterised in that** the transponder element (1) is coupled to the receptacle (4) via a thermally conductive component such that the transponder element (1) can be cooled or heated via the receptacle (4).

2. Communication apparatus as claimed in claim 1, **characterised in that** the holding element forms an antenna (3), which is attuned to the transponder element (1), as a transmission element.

3. Communication apparatus as claimed in claim 1, **characterised in that** an antenna (3) is provided as a transmission device between the holding element and the transponder element (1).

4. Communication apparatus as claimed in claim 3, **characterised in that** the holding element forms a high-frequency cover plate (7).

5. Communication apparatus as claimed in any one of claims 1 to 4, **characterised in that** the transponder element (1) has a sensor for measuring physical properties of the receptacle (4).

6. Communication apparatus as claimed in any one of claims 1 to 5, **characterised in that** the receptacle (4) forms a housing (9) which is provided with fastening elements.

## Revendications

1. Dispositif de communication destiné à être installé dans une zone dangereuse avec un réceptacle (4) présentant une ouverture orientée vers la zone dangereuse dans lequel un élément de transpondeur (1) est intégré dans une masse coulée (5) et avec un système de transmission relié par une ligne de signaux (2) avec l'élément de transpondeur (1), dans lequel la masse coulée (5) est dotée dans la zone de l'ouverture d'un bouclier thermique (6) protégé par un élément de support contre la charge mécanique appliquée contre la zone dangereuse, **caractérisé en ce que** l'élément de transpondeur (1) est couplé par un élément thermo-conducteur au réceptacle (4), de sorte que l'élément de transpondeur (1) peut être refroidi ou réchauffé par le réceptacle (4).

2. Dispositif de communication selon la revendication 1, **caractérisé en ce que** l'élément de support forme une antenne (3) adaptée à l'élément de transpondeur (1) en guise d'élément de transmission.

3. Dispositif de communication selon la revendication 1, **caractérisé en ce qu'**entre l'élément de support et l'élément de transpondeur (1), une antenne (3) est prévue en guise d'élément de transmission.

4. Dispositif de communication selon la revendication 3, **caractérisé en ce que** l'élément de support forme un diaphragme à haute fréquence (7).

5. Dispositif de communication selon une des revendications 1 à 4, **caractérisé en ce que** l'élément de transpondeur (1) présente un capteur pour mesurer les propriétés physiques du réceptacle (4).

6. Dispositif de communication selon une des revendications 1 à 5, **caractérisé en ce que** le réceptacle (4) forme un boîtier (9) muni d'éléments de fixation.
